# EUROPEAN PATENT APPLICATION

(11) **EP 4 712 732 A1**
(43) Date of publication of application: **18.03.2026**
(21) Application number: 24899110.1
(22) Date of filing: 16.04.2024
(51) Int. Cl.: H10F 10/00

(54) **BACK-CONTACT CELL, CELL STRING, CELL MODULE AND PHOTOVOLTAIC SYSTEM**

(30) Priority: 07.12.2023 CN 202311671762
(71) Applicant: Zhejiang Aiko Solar Energy Technology Co., Ltd., Yiwu, Jinhua Zhejiang 322000 (CN)
(72) Inventor: WANG, Yongqian, Jinhua, Zhejiang 322000 (CN); ZHANG, jianjun, Jinhua, Zhejiang 322000 (CN); CHEN, Gang, Jinhua, Zhejiang 322000 (CN)
(74) Representative: EP&C
(86) International application number: PCT/CN2024/087871
(87) International publication number: WO 2025/118457

(57) **Abstract**

The disclosure relates to the technical field of solar cells, and provides a back-contact cell (100), a battery string (201), a battery module (200) and a photovoltaic system (1000). In the back-contact cell (100), a back surface (11) of the silicon substrate (10) is provided with several first doped layers (12) and several second doped layers (13), the first doped layers (12) and the second doped layers (13) are arranged alternately in sequence in a first direction and extend in a second direction, and in the second direction, the silicon substrate (10) has a first edge (101) and a second edge (102) that are opposite each other. Several first fingers (20) and several second fingers (30) are spaced alternately in the first direction. The first fingers (20) has several first discontinuous areas which are spaced (21) in the second direction, the second fingers (30) has several second discontinuous areas which are spaced (31) in the second direction, and the first fingers (20) does not extend to the first edge (101) of the silicon substrate (10). A first edge combination gird line (40) is arranged close to the first edge (101) and extends in the first direction, and the first edge combination gird line (40) is electrically connected to the first fingers (20). A second edge combination gird line (50) extends in the first direction, is arranged between the first edge combination gird line (40) and the first edge (101) and is located above the second doped layers (13), and the second edge combination gird line (50) is in contact with at least one of the second doped layers (13) and is electrically connected to an end of a portion, closest to the first edge (101), of the second fingers 30.

## Description

### Cross-Reference to Related Application

The disclosure claims the priority to and benefit of Patent Application No. 202311671762.X filed with the China National Intellectual Property on December 7, 2023, which is incorporated herein by reference in its entirety.

### Technical Field

The disclosure relates to the technical field of solar cells, in particular to a back-contact cell, a battery string, a battery module, and a photovoltaic system.

### Background

A back-contact solar cell is a type of cell with a P-doped layer and an N-doped layer on the back surface of a silicon wafer. In the back-contact solar cell, alternately arranged fingers and alternately arranged busbars are arranged on the back surface, the busbars and the fingers cross each other, and the fingers are usually disconnected at the busbars with heteropolarity for avoiding electric leakage. In the related art, the fingers on the back surface of the back-contact solar cell typically do not extend to edges of the two sides of the silicon wafer, and parts of the edges have no metal fingers. As a result, carriers of parts of the edges cannot be collected, resulting in low efficiency and efficiency loss of carrier collection, and low efficiency of the cell.

### Summary

The disclosure provides a back-contact cell, a battery string, a battery module, and a photovoltaic system.

The disclosure is implemented as follows. The back-contact cell of examples of the disclosure includes:
a silicon substrate, where a back surface of the silicon substrate is provided with several first doped layers and several second doped layers, the first doped layers and the second doped layers are arranged alternately in sequence in a first direction and extend in a second direction, the first direction and the second direction cross each other, and in the second direction, the silicon substrate has a first edge and a second edge that are opposite each other;
several first fingers and several second fingers that are spaced alternately in the first direction, where the first fingers are arranged above the first doped layer, and the second fingers are arranged above the second doped layers; the first fingers have several first discontinuous areas which are spaced in the second direction, the second fingers have several second discontinuous areas which are spaced in the second direction, the first discontinuous areas on adjacent first fingers correspond in the first direction, and the second discontinuous areas on adjacent second fingers correspond in the first direction; and the first discontinuous areas and the second discontinuous areas are spaced alternately in sequence in the second direction, and the first fingers do not extend to the first edge of the silicon substrate;
a first edge combination gird line arranged close to the first edge and extending in the first direction, where the first edge combination gird line is electrically connected to the first fingers; and
a second edge combination gird line extending in the first direction, where the second edge combination gird line is arranged between the first edge combination gird line and the first edge and is located above the second doped layers, and the second edge combination gird line is in contact with at least one of the second doped layers and is electrically connected to an end of a portion, closest to the first edge, of the second fingers.

The disclosure further provides a battery string. The battery string includes several back-contact cells according to any one described above, where in two adjacent back-contact cells, a first discontinuous area of one back-contact cell corresponds to a second discontinuous area of the other back-contact cell in a first direction.

The disclosure further provides a battery module. The battery module includes several battery strings described above.

The disclosure further provides a photovoltaic system. The photovoltaic system includes the battery module described above.

Additional aspects and advantages of the disclosure will be set forth partially in the following description, will become partially apparent in the following description, or will be learned through implementation of the disclosure.

### Brief Description of the Drawings

Fig. 1 is a schematic structural diagram of a back-contact cell according to an example of the disclosure;
Fig. 2 is a partially enlarged schematic diagram of a back-contact cell according to an example of the disclosure;
Fig. 3 is a schematic diagram of a section of the back-contact cell in Fig. 1 at a second edge combination gird line;
Fig. 4 is another partially enlarged schematic diagram of a back-contact cell according to an example of the disclosure;
Fig. 5 is a schematic diagram of a section of the back-contact cell in Fig. 1 at a fourth edge combination gird line;
Fig. 6 is another partially enlarged schematic diagram of a back-contact cell according to an example of the disclosure;
Fig. 7 is another schematic structural diagram of a back-contact cell according to an example of the disclosure;
Fig. 8 is a schematic diagram of a section of the back-contact cell in Fig. 7 at a fourth edge combination gird line;
Fig. 9 is a schematic structural diagram of a battery string according to an example of the disclosure; and
Fig. 10 is a schematic structural diagram of a photovoltaic system according to an example of the disclosure.

### Detailed Description of the Embodiments

In order to make objectives, technical solutions, and advantages of the disclosure clearer, the disclosure will be further described below in detail with reference to accompanying drawings and examples. The instances of the examples are shown in the accompanying drawings, and identical or similar reference numerals indicate identical or similar elements or elements having identical or similar functions throughout. It should be noted that the examples described below with reference to the accompanying drawings are illustrative and are merely used to explain the disclosure, but cannot be construed as limitation to the disclosure. In addition, it should be understood that particular examples described herein are merely used to explain the disclosure rather than limit the disclosure.

In the description of the disclosure, it needs to be understood that orientation or positional relations indicated by terms "up", "down", "left", "right", "transverse", "longitudinal", etc. are based on orientation or positional relations shown in the accompanying drawings, are merely used for facilitating description of the disclosure and simplifying the description, rather than indicating or implying that a device or an element referred to needs to have a particular orientation or be constructed and operated in a particular orientation, and cannot be constructed as limitation to the disclosure as a result.

In addition, the terms such as "first" and "second" are used for descriptive purposes merely, and cannot be construed as indicating or implying relative importance or implicitly indicating the number of technical features indicated. Thus, features defined with "first" and "second" can explicitly or implicitly include one or more of the features. In the description of the disclosure, "several" means two or more than two, unless otherwise explicitly and specifically defined.

In the disclosure, unless otherwise specified and limited, a first feature "above" or "below" a second feature can indicate that the first feature is in direct contact with the second feature, or in indirect contact with the second feature by means of another feature therebetween. Further, the first feature "above", "over" or "on a top of" the second feature indicates that the first feature is over and obliquely above the second feature, or merely indicates that the first feature is higher than the second feature in horizontal height. The first feature "below", "under" or "on a bottom of" the second feature indicates that the first feature is under and obliquely below the second feature, or merely indicates that the first feature is lower than the second feature in horizontal height.

The following disclosure provides many different examples or instances for implementing different structures of the disclosure. In order to simplify the disclosed contents of the disclosure, parts and settings of specific instances are described below. Apparently, the instances are merely illustrative, and are not intended to limit the disclosure. In addition, reference numerals and/or reference letters may be repeated in different instances of the disclosure. This repetition is for the purpose of simplification and clarity, and itself does not indicate relations between various examples and/or settings discussed. In addition, the disclosure provides instances of various specific processes and materials, but a person of ordinary skill in the art may conceive applications of other processes and/or use scenarios of other materials.

### Embodiment 1

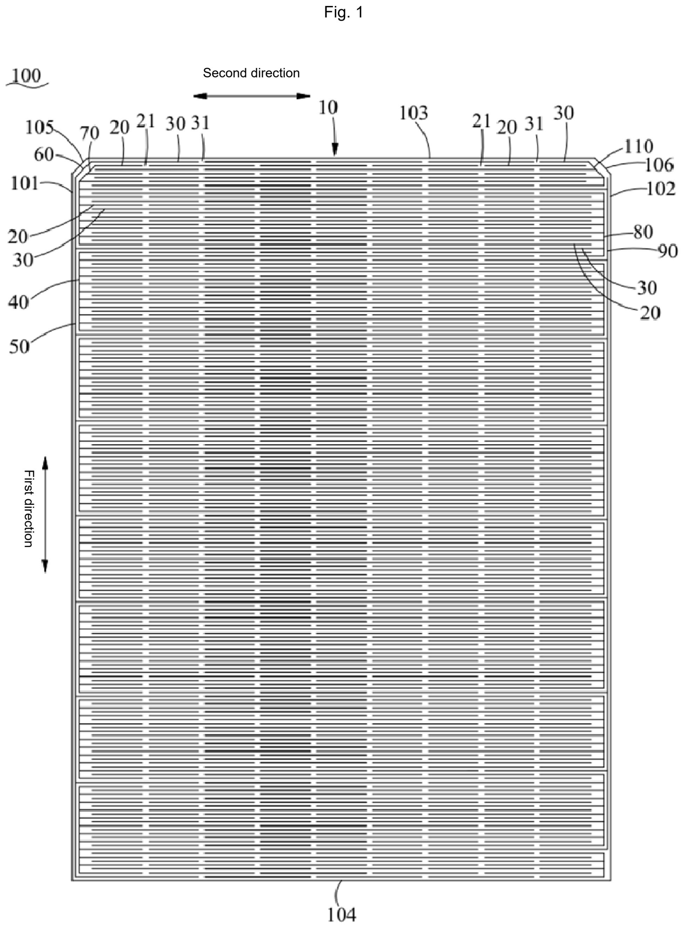

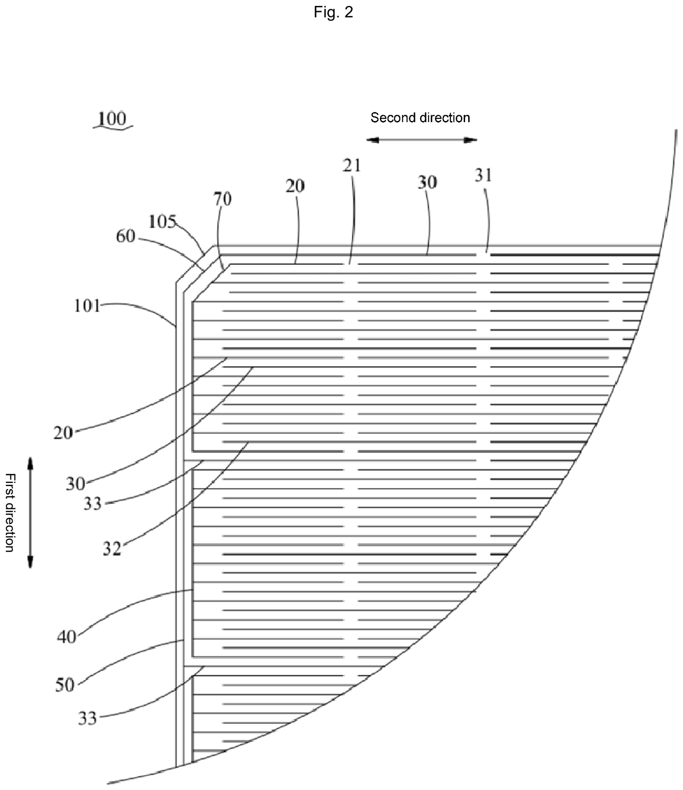

With reference to Fig. 1 and Fig. 2, a back-contact cell 100 in the example of the disclosure may include a silicon substrate 10, several first fingers 20, several second fingers 30, a first edge combination grid line 40, and a second edge combination grid line 50.

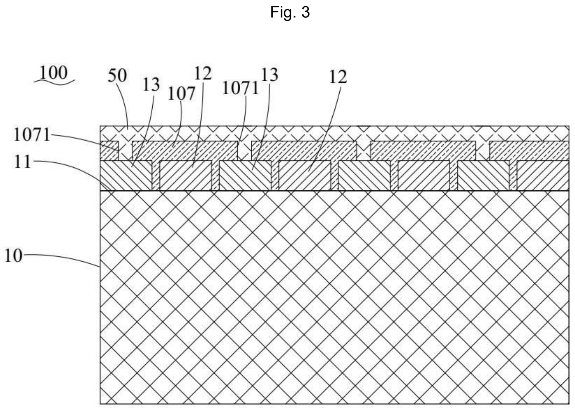

With reference to Fig. 3, a back surface 11 of the silicon substrate 10 is provided with several first doped layers 12 and several second doped layers 13, the several first doped layers 12 and the several second doped layers 13 are arranged alternately in sequence in a first direction and extend in a second direction, the first direction and the second direction cross each other, and in the second direction, the silicon substrate 10 has a first edge 101 and a second edge 102 that are opposite each other.

The first doped layers 12 and the second doped layers 13 have opposite polarities. For example, the first doped layers 12 may be a P-type doped layer and the second doped layers 13 may be an N-type doped layer. For example, the first doped layers 12 may be an N-type doped layer and the second doped layers 13 may be a P-type doped layer, which is not limited specifically herein. The first doped layers 12 and the second doped layers 13 may be arranged at an interval preferably, and the first doped layers 12 and the second doped layers 13 may both extend to the first edge 101 and the second edge 102 of the silicon substrate 10. Preferably, the first direction may be a longitudinal direction of the back-contact cell 100 and the second direction may be a transverse direction of the back-contact cell 100, and the longitudinal direction is perpendicular to the transverse direction. It is clear that in other examples, the first direction may alternatively not be perpendicular to the second direction, or the first direction and the second direction may not be the transverse direction and the longitudinal direction respectively, for example, the first direction and the second direction may be diagonal directions of the silicon substrate 10, which is not limited specifically herein.

As shown in Fig. 1, the first fingers 20 and the second fingers 30 are spaced alternately in the first direction. The first fingers 20 are arranged above the first doped layers 12 and the second fingers 30 are arranged on the second doped layers 13. The first fingers 20 are used for collecting currents of the first doped layers 12 and the second fingers 30 are used for collecting currents of the second doped layers 13.

As shown in Fig. 1, the first fingers 20 have several first discontinuous areas 21 which are spaced in the second direction, the second fingers 30 have several second discontinuous areas 31which are spaced in the second direction, the first discontinuous areas 21 on adjacent first fingers 20 correspond in the first direction, and the second discontinuous areas 31 on adjacent second fingers 30 correspond in the first direction. The first discontinuous areas 21 and the second discontinuous areas 31 are spaced alternately in sequence in the second direction, and the the first fingers 20 does not extend to the first edge 101 of the silicon substrate 10.

It should be noted that a case that "the first discontinuous areas 21 on adjacent first fingers 20 correspond in the first direction, and the second discontinuous areas 31 on adjacent second fingers 30 correspond in the first direction" indicates that the first discontinuous areas 21 are basically aligned and the second discontinuous areas 31 are also basically aligned in the first direction. A case that "the first discontinuous areas 21 and the second discontinuous areas 31 are spaced alternately in sequence in the second direction" indicates that the first discontinuous areas 21 and the second discontinuous areas 31 are arranged alternately in sequence in the second direction in the entire back-contact cell 100.

Specifically, the first discontinuous area 21 and the second discontinuous area 31 may be used for the busbar and/or a solder strip to be arranged so as to implement combination output.

With reference to Fig. 1 and Fig. 2, a first edge combination grid line 40 is arranged close to the first edge 101 and extends in the first direction, and the first edge combination grid line 40 is electrically connected to the first finger 20.

A second edge combination grid line 50 extends in the first direction, is arranged between the first edge combination grid line 40 and the first edge 101 and is located above the second doped layers 13, and the second edge combination grid line 50 is in contact with at least one of the second doped layers 13 and is electrically connected to an end of a portion, closest to the first edge 101, of the second finger 30.

Specifically, the second edge combination grid line 50 may be directly connected to some of the second fingers 30 or connected to some of the second fingers 30 through other connection lines (such as a first auxiliary grid line 60 hereinafter). It should be noted that the "some of the second fingers 30" indicates one second finger 30 or a plurality of second fingers 30, but not all of the second fingers 30.

**In** the related art, the back finger of the back-contact solar cell usually does not extend to edges of two sides of a silicon wafer. **If** the back finger extends to the edges of the silicon wafer, it is necessary to arrange the busbar and/or the solder strip in the edge area, to be connected to the finger in the edge area in order to collect the currents of the finger in the edge area. If the finger having an opposite polarity with the busbar and/or the solder strip extends to the edge of the silicon wafer, an insulating glue needs to be coated between the solder strip at the edge position and each finger having the opposite polarity in order to avoid the solder strip at an edge position being in contact with the finger having the opposite polarity. Thus, cost is greatly increased, and glue leakage is likely to be caused, and further causes bending and warping of the cell. However, if the finger does not extend to the edge of the silicon wafer, the edge has no metal finger partially, and carriers of a partial area of the edge cannot be collected, resulting in low efficiency and efficiency loss of carrier collection, and low efficiency of the cell.

In the back-contact cell 100 of the example of the disclosure, the first finger 20 does not extend to the first edge 101 of the silicon substrate 10, the first edge combination grid line 40 is arranged close to the first edge 101 and extends in the first direction, and the first edge combination grid line 40 is electrically connected to the first finger 20. The second edge combination grid line 50 extends in the first direction and is arranged between the first edge combination grid line 40 and the first edge 101, and the second edge combination grid line 50 is in contact with the at least one of the second doped layers 13 and is electrically connected to the end of the portion, closest to the first edge 101, of the second finger 30. In this way, the second edge combination grid line 50 is arranged between the first edge 101 and the first edge combination grid line 40, and the second edge combination grid line 50 is in contact with the at least one of the second doped layers 13 and is connected to some of the second fingers 30. Thus, the second edge combination grid line 50 can collect the currents of the second doped layers 13 in the edge area of the first edge 101 and combine the currents to an adjacent busbar and/or solder strip having the same polarity through some of the second fingers 30, the current collection is implemented, the efficiency loss of the edge area of the first edge 101 can be effectively reduced, and the efficiency of the cell is improved.

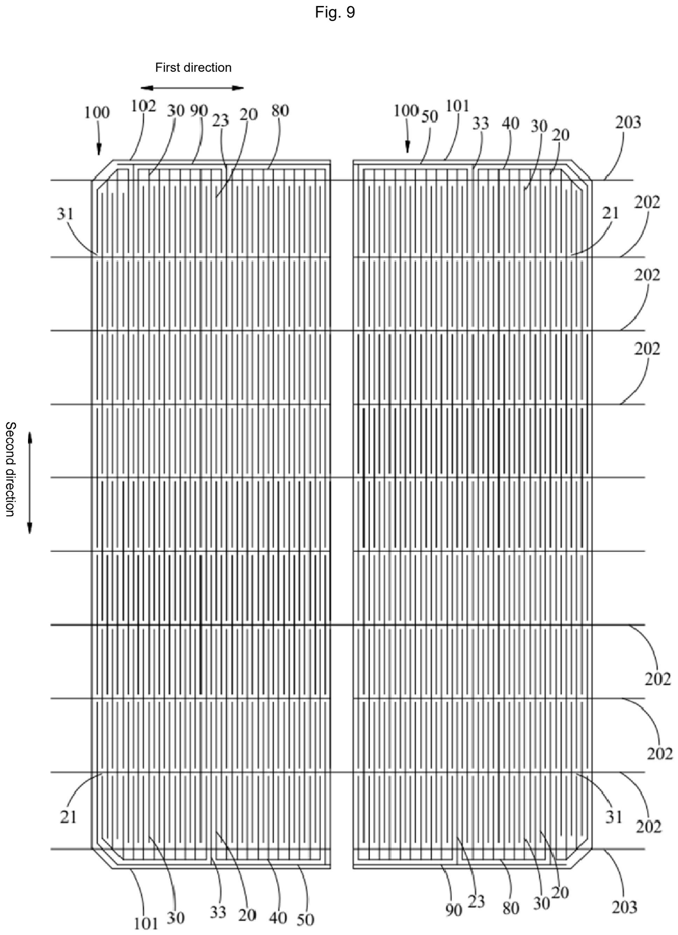

Moreover, since merely some of the second fingers 30 are connected to the second edge combination grid line 50, in a subsequent soldering process of the solder strip having the opposite polarity (such as the edge solder strip 203 in Fig. 9), the solder strip and some of the second fingers 30 or the connection lines (such as the first auxiliary grid lines 60 hereinafter) connecting the second fingers 30 to the second edge combination grid line 50 cross each other merely, few crossing points exit, and merely the few points need to be coated with the insulating glues for avoiding the electric leakage, thus reducing the cost effectively. In addition, the points coated with the insulating glues are isolated points, such that the glue leakage and the bending and warping of the cell are not likely to be caused. That is, by adopting the technical solution of the disclosure, while the cost of the insulating glue can be reduced, and the bending and warping of the cell due to the glue leakage can be avoided, the efficiency loss can be effectively reduced, and the efficiency of the cell is guaranteed. In addition, through arrangement of the first edge combination grid line 40, a grid line breakage preventing function of the first finger 20 can also be implemented, and grid line breakage of the first finger 20 can be avoided as much as possible.

Specifically, in the example of the disclosure, the first doped layers 12 and the second doped layers 13 have opposite polarities, and the first finger 20 and the second finger 30 also have opposite polarities. For example, the first finger 20 is a positive finger line used for collecting positive currents in a positive area, and the second finger 30 is a negative finger line used for collecting negative currents in a negative area. Alternatively, the first finger 20 is a negative finger line used for collecting negative currents in a negative area, and the second finger 30 is a positive grid line used for collecting positive currents in a positive area. The positive finger line is arranged on the P-type doped layer of the back-contact cell 100, and the negative finger line is arranged on the N-type doped layer of the back-contact cell 100.

In the example of the disclosure, the back-contact cell 100 may be a substantial rectangle. The term substantial rectangle indicates that the back-contact cell 100 may be a square, a rectangle or a rectangle with a standard chamfer and a rounded corner, which is arranged according to actual production demand and is not limited herein. In addition, a number of first fingers 20 and a number of second fingers 30 are determined according to an actual area of the back-contact cell 100, widths of the first finger 20 and the second finger 30, and a distance between the first finger and the second finger, which is not limited specifically herein.

In the example of the disclosure, a case that "the first finger 20 has several first discontinuous areas 21 which are spaced" means that the first finger 20 has a discontinuous structure, and the first finger 20 is separated at the first discontinuous areas 21, that is, the first discontinuous areas 21 separate the first finger 20 into several portions. Similarly, a case that "the second finger 30 has several second discontinuous areas 31which are spaced" means that the second finger 30 has a discontinuous structure, and the second finger 30 is separated at the second discontinuous areas 31, that is, the second discontinuous areas 31 separate the second finger 30 into several portions.

In the example shown in the figure, the "first edge 101" indicates a left edge in Fig. 1, and the "second edge 102" indicates a right edge in Fig. 1. Both the first edge combination grid line 40 and the second edge combination grid line 50 may be arranged parallel to the first edge 101 and the second edge 102 respectively, and the first finger 20 and the second finger 30 are arranged perpendicular to the first edge 101 and the second edge 102 respectively.

In the example of the disclosure, in order to reduce difficulty of process manufacturing, no first finger 20 is arranged between the first edge combination grid line 40 and the first edge 101 preferably, and no first finger 20 or second finger 30 is arranged between the second edge combination grid line 50 and the first edge 101 preferably. It can be understood clearly that in some examples, the second finger 30 may be arranged between the second edge combination grid line 50 and the first edge 101, and the first finger 20 may not be arranged between the second edge combination grid line and the first edge, which is not limited specifically herein.

Further, in the example of the disclosure, the first finger 20 and the second finger 30 may be aluminum grid lines, silver grid lines, copper grid lines, or silver-clad copper grid lines, which are not limited herein.

It can be understood that in the example of the disclosure, grid lines of the same type or different metal types may be selected as the first finger 20 and the second finger 30. For example, the aluminum grid line is selected as the first finger 20 and the second finger 30, or the aluminum grid line is selected as the first finger 20, and the silver grid line is selected as the second finger 30.

As shown in Fig. 2 and Fig. 3, it is not difficult to understand that the second edge combination grid line 50 is in contact with the second doped layers 13 to collect the currents of the second doped layers 13 in the edge area. Thus, in the example of the disclosure, of the first discontinuous area 21 of the first finger 20 and the second discontinuous area 31 of the second finger 30, the first discontinuous area 21 is closest to the first edge 101. That is, in the second direction, the first discontinuous areas 21 and the second discontinuous areas 31 are arranged alternately in sequence. At a position corresponding to the first discontinuous area 21, the second finger 30 is not discontinuous, and the busbar and/or the solder strip in contact with the second finger 30 may be arranged at the position corresponding to the first discontinuous area 21 so as to combine the currents of the first edge combination grid line 40.

### Embodiment 2

With reference to Fig. 2, in some examples, some of second fingers 30 penetrate a first edge combination grid line 40 in an insulated way so as to be electrically connected to a second edge combination grid line 50.

In this way, after the second edge combination grid line 50 collects currents of a second doped layer 13 in an edge area of a first edge 101, the second edge combination grid line may combine the currents to a nearest busbar and/or solder strip having the same polarity through the second finger 30 penetrating the first edge combination grid line 40, so as to implement current collection.

Specifically, as shown in Fig. 2, in such an example, several second fingers 30 may include several first collecting fingers 32 and several first penetrating fingers 33. The several first collecting fingers 32 are all located on a side, facing a second edge 102, of the first edge combination grid line 40, and the first penetrating fingers 33 penetrate the first edge combination grid line 40 in an insulated way so as to be connected to the second edge combination grid line 50.

That is, in such an example, no first collecting finger 32 is arranged between the first edge combination grid line 40 and the first edge 101. Between the first edge combination grid line 40 and the first edge 101, merely a position penetrated by the first edge combination grid line 40 has the first penetrating finger 33, and the remaining positions have no fingers (including the first finger 20 and the second finger 30).

It should be noted that in the example of the disclosure, a case that "some of the second fingers 30 penetrate the first edge combination grid line 40 in an insulated way" may be understood as that several spaced partition areas are arranged on the first edge combination grid line 40 in a first direction, and the first penetrating fingers 33 pass through the first edge combination grid line 40 through the partition areas without being in contact with the first edge combination grid line 40, so as to implement physical penetration and insulated isolation.

It can be understood that in such an example, one or more first penetrating fingers 33 may be arranged, and a specific number of first penetrating fingers may be determined according to a size of the cell. When a plurality of first penetrating fingers 33 are arranged, the plurality of first penetrating fingers 33 may be spaced in the first direction, and a distance between two adjacent first penetrating fingers 33 may be determined according to the size of the cell. Preferably, the first penetrating fingers may be uniformly spaced on a silicon substrate 10 in the first direction according to a size of the silicon substrate 10, which is not limited specifically herein.

It is not difficult to understand that in such an example, the second edge combination grid line 50 may collect the currents of the second doped layers 13 in the edge area of the first edge 101, and then combine the currents to the nearest busbar and/or solder strip (such as a solder strip 202 hereinafter) having the same polarity through the first penetrating finger 33 penetrating the first edge combination grid line 40, so as to implement combination. A combination path can be effectively shortened and loss can be reduced by providing the plurality of first penetrating fingers 33.

### Embodiment 3

With reference to Fig. 1 and Fig. 2, in some examples, in a first direction, a silicon substrate 10 has a third edge 103 and a fourth edge 104 that are opposite, and the third edge 103 is connected to a first edge 101 through a first chamfer 105.

Second fingers 30 and first fingers 20 are arranged alternately in sequence in a direction from the third edge 103 to the fourth edge 104, a first auxiliary grid line 60 is arranged at the first chamfer 105, and the first auxiliary grid line 60 connects a second edge combination grid line 50 and the second finger 30 closest to the third edge 103.

In this way, by arranging the first auxiliary grid line 60 at the first chamfer 105, currents collected by the second edge combination grid line 50 can be combined to the second finger 30 at the third edge 103 so as to be combined to a nearest busbar and/or solder strip.

Specifically, as shown in Fig. 1, the third edge 103 is an upper edge of the silicon substrate 10, the fourth edge 104 is a lower edge of the silicon substrate 10, and the first edge 101 and the third edge 103 form the first chamfer 105. In such an example, the first auxiliary grid line 60 is arranged at the first chamfer 105 to connect the second edge combination grid line 50 to the uppermost second finger 30, and the currents collected by the second edge combination grid line 50 may be combined through the first auxiliary grid line 60 and may be combined to an adjacent busbar and/or solder strip through the second finger 30 connected to the first auxiliary grid line 60. That is, the second edge combination grid line 50 may be electrically connected to the uppermost second finger 30 through the first auxiliary grid line 60.

It can be understood that in such an example, the first penetrating finger 33 in Example 2 may be arranged to implement current combination with the first auxiliary grid line 60. The first penetrating finger 33 in Example 2 may alternatively be not arranged, but the current combination may be implemented through the first auxiliary grid line 60 at the first chamfer 105. It is clear that in order to avoid excessive loss caused by an excessively long transfer path of the current combination, the current combination is preferably implemented through the first penetrating finger 33 or through both the first penetrating finger 33 and the first auxiliary grid line 60, which is not limited herein.

As shown in Fig. 2, in some examples, the first auxiliary grid line 60 may be arranged parallel to the first chamfer 105. In this way, a grid line structure of a back surface 11 can become simpler to manufacture.

Further, in some examples, the first auxiliary grid line 60 may be located above second doped layers 13 and is in contact with at least one of the second doped layers 13.

In this way, the first auxiliary grid line 60 can collect the currents at an edge area at a position of the first chamfer 105 while implementing the current combination, thus further reducing efficiency loss and improving efficiency of the cell.

With reference to Fig. 1 and Fig. 2, in some examples, a second auxiliary grid line 70 may be further arranged at the first chamfer 105. The second auxiliary grid line 70 connects the first finger 20 located at the first chamfer 105 to the first edge combination grid line 40. It should be noted that "the first finger 20 located at the first chamfer 105" indicates the first finger 20 that is not directly connected to the first edge combination grid line 40 and crosses the first chamfer 105 along an extension line of the second direction among the first fingers 20, for example, top two first fingers 20 in Fig. 2.

In this way, the first fingers 20 at the first chamfer 105 can be connected through the arrangement of the second auxiliary grid line 70 so as to implement communication between the first fingers 20 at the first chamfer 105. When the solder strip (such as an edge solder strip 203 hereinafter) is soldered later, the currents of the first finger 20 at the first chamfer 105 can be collected merely through contact between the solder strip and the second auxiliary grid line 70. A case that the currents of the first finger 20 at the first chamfer 105 cannot be collected since the solder strip cannot be in contact with all the first fingers 20 at the first chamber 105 when the solder strip is soldered later due to existence of the first chamfer 105 can be avoided.

Specifically, as shown in Fig. 2, in such an example, the second auxiliary grid line 70 may alternatively be arranged parallel to the first chamfer 105. That is, at the first chamfer 105, the first chamfer 105, the first auxiliary grid line 60 and the second auxiliary grid line 70 are sequentially arranged parallel to one another from an outer side to an inner side.

As shown in Fig. 2, it is not difficult to understand that since the first finger 20 has a first discontinuous area 21 at a position closest to the first edge 101, in order to implement current combination at the first finger 20 near the first edge 101, it is necessary to arrange the solder strip at the position of the first edge 101, to be in conductive connection to the first finger 20 for current combination. Due to the existence of the first chamfer 105, a length of the first finger 20 at the top is small, and the solder strip may not be in contact with the first finger 20 at the top when the solder strip is vertically arranged. However, if the solder strip is too close to the inner side, the solder strip is likely to be in contact with the second finger 30 having the opposite polarity, resulting in electric leakage. Thus, by arranging the second auxiliary grid line 70, the first fingers 20 at the first chamfer 105 can be connected into a whole. When the solder strip is soldered, the currents of all the first fingers 20 can be combined merely through contact of the solder strip with the first edge combination grid line 40 or with both the first edge combination grid line 40 and the second auxiliary grid line 70 or with the remaining first fingers 20 and the second auxiliary grid line 79 that are connected to the first edge combination grid line 40.

### Embodiment 4

In some examples, a distance between a first edge combination grid line 40 and a first edge 101 (that is, a gap between the first edge combination grid line and the first edge in a second direction) is 0.5 mm-2 mm.

In this way, if the gap between the first edge combination grid line 40 and the first edge 101 is set within this reasonable range, a case that excessively high efficiency loss is caused since an area without the finger is excessively large due to an excessively large distance between the first edge combination grid line and the first edge can be effectively avoided, a case that insufficient solder and cracking are caused by an excessively small distance between the first edge combination grid line and the first edge when the solder strip is soldered at the first edge combination grid line 40 later can be also avoided, and reliability and stability of soldering are guaranteed.

Specifically, in such an example, the distance between the first edge combination grid line 40 and the first edge 101 may be, for example, 0.5 mm, 0.6 mm, 0.7 mm, 0.8 mm, 0.9 mm, 1 mm, 1.2 mm, 1.4 mm, 1.6 mm, 1.8 mm, 2 mm or any value within 0.5 mm-2 mm, which is not limited specifically herein.

Further, in the example of the disclosure, the distance between the first edge combination grid line 40 and the first edge 101 is preferably 0.8 mm-1.2 mm, for example, 0.9 mm. In this way, while the process difficulty can be reduced, the excessively high efficiency loss caused by an excessively large area of the edge area due to the excessively large distance can be effectively avoided, and the stability and reliability of soldering can also be guaranteed.

### Embodiment 5

In some examples, a distance between a second edge combination grid line 50 and a first edge 101 (that is, a gap between the second edge combination grid line and the first edge in a second direction) is 0.3 mm-1.2 mm
In this way, on the one hand, a great increase in printing difficulty of the second edge combination grid line 50 due to an excessively small distance between the second edge combination grid line 50 and the first edge 101 can be avoided, and on the other hand, excessively high efficiency loss due to an excessively large distance between the second edge combination grid line 50 and the first edge 101 can be avoided.

Specifically, in such an example, the distance between the second edge combination grid line 50 and the first edge 101 may be, for example, 0.3 mm, 0.4 mm, 0.5 mm, 0.6 mm, 0.7 mm, 0.8 mm, 0.9 mm, 1 mm, 1.2 mm or any value within 0.3 mm-1.2 mm, which is not limited specifically herein.

Further, in the example of the disclosure, the distance between the second edge combination grid line 50 and the first edge 101 is preferably 0.3mm-0.6mm, for example, 0.5 mm. In this way, while the process difficulty can be reduced, the excessively high efficiency loss caused by an excessively large area of the edge area due to the excessively large distance can be effectively avoided. That is, while the printing difficulty can be reduced, the excessively high efficiency loss can be avoided.

### Embodiment 6

In some examples, a width of a second edge combination grid line 50 may be 20 um-200 um.

In this way, by setting the width of the second edge combination grid line 50 within this reasonable range, the phenomenon of fusing during current combination due to an excessively small overcurrent capacity caused by an excessively small width of the second edge combination grid line 50 can be avoided, and a great increase in cost caused by an excessively large width of the second edge combination grid line 50 can also be avoided.

Specifically, in such an example, the width of the second edge combination grid line 50 may be, for example, 20 um, 20 um, 30 um, 40 um, 50 um, 60 um, 70 um, 80 um, 90 um, 100 um, 110 um, 120 um, 130 um, 140 um, 150 um, 160 um, 170 um, 180 um, 190 um, 200 um or any value within 20 um-200 um, which is not limited specifically herein.

In some examples, the width of the second edge combination grid line 50 may be greater than a width of a first edge combination grid line 40.

In this way, since the second edge combination grid line 50 is used for collecting currents of second doped layers 13 in an edge area, and plays a role of collection and combination, the width of the second edge combination grid line 50 may be set to be greater than the width of the first edge combination grid line 40, in order to improve an overcurrent capacity of the second edge combination grid line 50 and guarantee stability of a cell.

### Embodiment 7

With reference to Fig. 3, in some examples, passivation film layers 107 are further arranged on a first doped layer 12 and a second doped layer 13, a second edge combination grid line 50 is arranged on the passivation film layer 107, a first opening 1071 is provided in a position, corresponding to the second doped layers 13, of the passivation film layer 107 on an area (a projection area of the second edge combination grid line 50 on the passivation film layer 107) corresponding to the second edge combination grid line 50, and the second edge combination grid line 50 is in contact with the second doped layers 13 through the first opening 1071.

In this way, by providing the first opening 1071 in the position, corresponding to the second doped layers 13 in the passivation film layer 107, the second edge combination grid line 50 can be in stable contact with the second doped layers 13 at a bottom of an edge area during printing so as to collect currents, and electric leakage caused by contact between the second edge combination grid line 50 and the first doped layers 12 can also be avoided.

Specifically, in such an example, the first opening 1071 may be provided in the passivation film layer 107 through laser hole cutting. In order to maximize current collection, the first openings 1071 are cut in all the second doped layers 13 preferably, and the second edge combination grid line 50 is in contact with all the second doped layers 13 through the first openings 1071 so as to maximize the current collection. It can be understood that in such an example, the first openings 1071 may be provided in all the second doped layers 13, or the first openings 1071 may be provided in some of the second doped layers 13, which is not limited specifically herein.

### Embodiment 8

With reference to Fig. 1, Fig. 4 and Fig. 5, in some examples, a back-contact cell 100 may further include a third edge combination grid line 80 and a fourth edge combination grid line 90.

The third edge combination grid line 80 is arranged close to a second edge 102 and extends in a first direction. The third edge combination grid line 80 is electrically connected to a second finger 30, the second finger 30 does not extend to the second edge 102 of a silicon substrate 10, and the third edge combination grid line 80 and a first edge combination grid line 40 have opposite polarities.

The fourth edge combination grid line 90 also extends in the first direction, and the fourth edge combination grid line 90 is arranged between the third edge combination grid line 80 and the second edge 102 and is located above a first doped layer 12. The fourth edge combination grid line 90 and a second edge combination grid line 50 has opposite polarities, and the fourth edge combination grid line is in contact with at least one of first doped layers 12 and is electrically connected to an end of a portion, closest to the second edge 102, of the first finger 20.

**In** this way, the fourth edge combination grid line 90 is arranged between the second edge 102 and the third edge combination grid line 80, and the fourth edge combination grid line 90 is in contact with the at least one of the first doped layers 12 and is connected to some of the second fingers 20. Thus, the fourth edge combination grid line 90 can collect the currents of the first doped layers 12 in the edge area of the second edge 102 and combine the currents to an adjacent busbar and/or solder strip having the same polarity through some of the first fingers 20, current collection is implemented, efficiency loss of the edge area of the second edge 102 can be effectively reduced, and efficiency of the cell is improved.

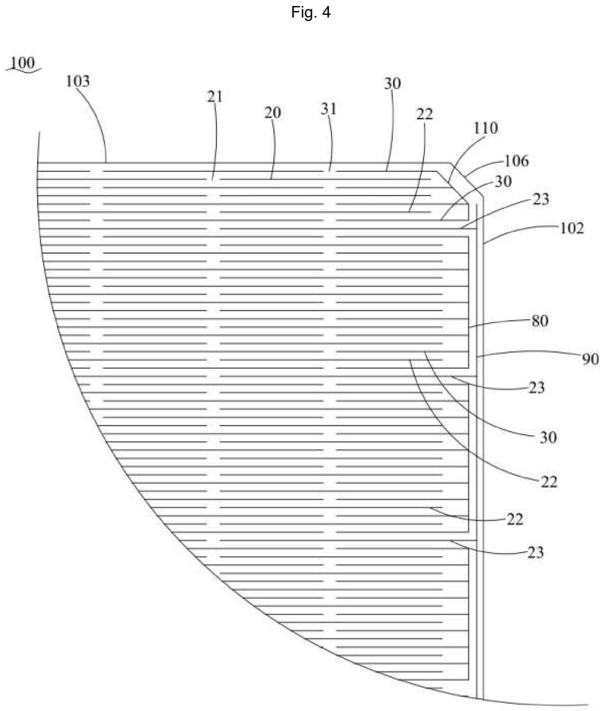

Moreover, as shown in Fig. 4, since merely some of the first fingers 20 are connected to the fourth edge combination grid line 90, in a subsequent soldering process of the solder strip having the opposite polarity (such as the edge solder strip 203 in Fig. 9), the solder strip and some of the first fingers 20 cross each other merely, few crossing points exit, and merely the few points need to be coated with insulating glues for avoiding electric leakage, thus reducing the cost effectively. In addition, the points coated with the insulating glues are isolated points, such that the glue leakage and the bending and warping of the cell are not likely to be caused. In addition, through arrangement of the third edge combination grid line 80, a grid line breakage preventing function of the second finger 30 can also be implemented, and grid line breaking of the second finger 30 can be avoided as much as possible.

Specifically, in such an example, the third edge combination grid line 80 at the second edge 102 and the first edge combination grid line 40 at the first edge 101 have opposite polarities, and one of the third edge combination grid line and the first edge combination grid line is a positive grid line and the other is a negative grid line. The fourth edge combination grid line 90 at the second edge 102 and the second edge combination grid line 50 at the first edge 101 have opposite polarities, one of the fourth edge combination grid line and the second edge combination grid line is a positive grid line and the other of the fourth edge combination grid line and the second edge combination grid line is a negative grid line.

The second edge combination grid line 50 is used for collecting currents of a second doped layer 13 in the edge area of the first edge 101, and the fourth edge combination grid line 90 is used for collecting the currents of the first doped layers 12 in the edge area of the second edge 102.

It can be understood that in such an example, structures and materials of the third edge combination grid line 80 and the first edge combination grid line 40 are basically the same, and structures and materials of the fourth edge combination grid line 90 and the second edge combination grid line 50 are basically the same, which will not be repeated herein.

As shown in Fig. 1, it is not difficult to understand that the fourth edge combination grid line 90 is in contact with the first doped layers 12 to collect the currents of the second doped layer 12 in the edge area. Thus, as shown in Fig. 4, in this example, a number of first discontinuous areas 21 and a number of second discontinuous areas 31 are even numbers, of the first discontinuous area 21 of the first finger 20 and the second discontinuous area 31 of the second finger 30, the second discontinuous area 31 is closest to the second edge 102. That is, in a second direction, the first discontinuous areas 21 and the second discontinuous areas 31 are arranged alternately in sequence. A discontinuous area closest to the second edge 102 is the second discontinuous area 31. At a position corresponding to the second discontinuous area 31, the first finger 20 is not discontinuous, and the busbar and/or the solder strip in contact with the first finger 20 may be arranged at the position corresponding to the second discontinuous area 31, so as to combine the currents collected by the fourth edge combination grid line 90.

### Embodiment 9

With reference to Fig. 1 and Fig. 4, in some examples, some of first fingers 20 penetrate a third edge combination grid line 80 in an insulated way so as to be connected to a fourth edge combination grid line 90.

In this way, after the fourth edge combination grid line 90 collects currents of an edge area, the fourth edge combination grid line may combine the currents to a nearest busbar and/or solder strip having the same polarity through the first finger 20 penetrating the third edge combination grid line 80, so as to implement current collection.

Specifically, as shown in Fig. 4, in such an example, several first fingers 20 may include several second collecting fingers 22 and several second penetrating fingers 23. The several second collecting fingers 22 are all located on a side, facing a first edge 101, of the third edge combination grid line 80, and the second penetrating fingers 23 penetrate the third edge combination grid line 80 in an insulated way so as to be connected to the fourth edge combination grid line 90.

That is, in such an example, no second collecting finger 22 is arranged between the third edge combination grid line 80 and the second edge 102. Between the third edge combination grid line 80 and the second edge 102, merely a position penetrated by the second edge combination grid line 50 has the second penetrating finger 23, and the remaining positions have no fingers (including the first finger 20 and the second finger 30).

It should be noted that in the example of the disclosure, a case that "some of the first fingers 20 penetrate the third edge combination grid line 80 in an insulated way" may be understood as that several spaced partition areas are arranged on the third edge combination grid line 80 in a first direction, and the second penetrating finger 23 passes through the third edge combination grid line 80 through the partition areas without being in contact with the third edge combination grid line 80, so as to implement physical penetration and insulated isolation.

It can be understood that in such an example, one or more second penetrating fingers 23 may be arranged, and a specific number of second penetrating fingers may be determined according to a size of a cell. When a plurality of second penetrating fingers 23 are arranged, the plurality of second penetrating fingers 23 may be spaced in the first direction, and a distance between two adjacent second penetrating fingers 23 may be determined according to the size of the cell. Preferably, the second penetrating fingers may be uniformly spaced on a silicon substrate 10 in the first direction according to a size of the silicon substrate 10, which is not limited specifically herein.

It is not difficult to understand that in such an example, the fourth edge combination grid line 90 may collect the currents of a first doped layer 12 in an edge area of the second edge 102, and then combine the currents to the nearest busbar and/or solder strip (such as a solder strip 202 hereinafter) having the same polarity through the second penetrating finger 23 penetrating the third edge combination grid line 80, so as to implement combination. A combination path can be effectively shortened and loss can be reduced by providing the plurality of second penetrating fingers 23.

### Embodiment 10

With reference to Fig. 1 and Fig. 4, in some examples, in a first direction, a silicon substrate 10 has a third edge 103 and a fourth edge 104 that are opposite, and the third edge 103 is connected to the second edge 102 through a second chamfer 106.

Second fingers 30 and first fingers 20 are arranged alternately in sequence in a direction from the third edge 103 to the fourth edge 104, a third auxiliary grid line 110 is arranged at the second chamfer 106, and the third auxiliary grid line 110 connects the second finger 30 at the second chamfer 106 and a third edge combination grid line 80. It should be noted that "the second finger 30 located at the second chamfer 106" indicates the first finger 30 that is not directly connected to the third edge combination grid line 80 and crosses the second chamfer 106 along an extension line of the second direction among several second fingers 30, for example, two uppermost second fingers 30 in Fig. 4.

In this way, the second fingers 30 at the second chamfer 106 can be connected through the arrangement of the third auxiliary grid line 110 so as to implement communication between the second fingers 30 at the second chamfer 106. When a solder strip (such as an edge solder strip 203 hereinafter) is soldered later, currents of the second finger 30 at the second chamfer 106 can be collected merely through contact between the solder strip and the third auxiliary grid line 110. A case that the currents of the second finger 30 at the second chamfer 106 cannot be collected since the solder strip cannot be in contact with all the second fingers 30 at the second chamber 106 when the solder strip is soldered later due to existence of the second chamfer 106 can be avoided.

Specifically, as shown in Fig. 4, in such an example, the third auxiliary grid line 110 may be arranged parallel to the second chamfer 106, such that a grid line structure of a back surface 11 is simpler to manufacture.

As shown in Fig. 4, it is not difficult to understand that since the second finger 30 has a second discontinuous area 31 at a position closest to the second edge 102, in order to implement current combination at the second finger 30 near the second edge 102, it is necessary to arrange the solder strip at the position of the second edge 102, to be in conductive connection to the second finger 30 for current combination. Due to the existence of the second chamfer 106, a length of the second finger 30 at the top is small, and the solder strip may not be in contact with the second finger 30 at the top when the solder strip is vertically arranged. However, if the solder strip is too close to the inner side, the solder strip is likely to be in contact with the first finger 20 having the opposite polarity, resulting in electric leakage. Thus, by arranging the third auxiliary grid line 110, the second fingers 30 at the second chamfer 106 can be connected into a whole. When the solder strip is soldered, the currents of all the second fingers 30 can be combined merely through contact of the solder strip with the third edge combination grid line 80 or with both the third edge combination grid line 80 and the third auxiliary grid line 110 or with the remaining second fingers 30 and the third auxiliary grid line 110 that are connected to the third edge combination grid line 80.

### Embodiment 11

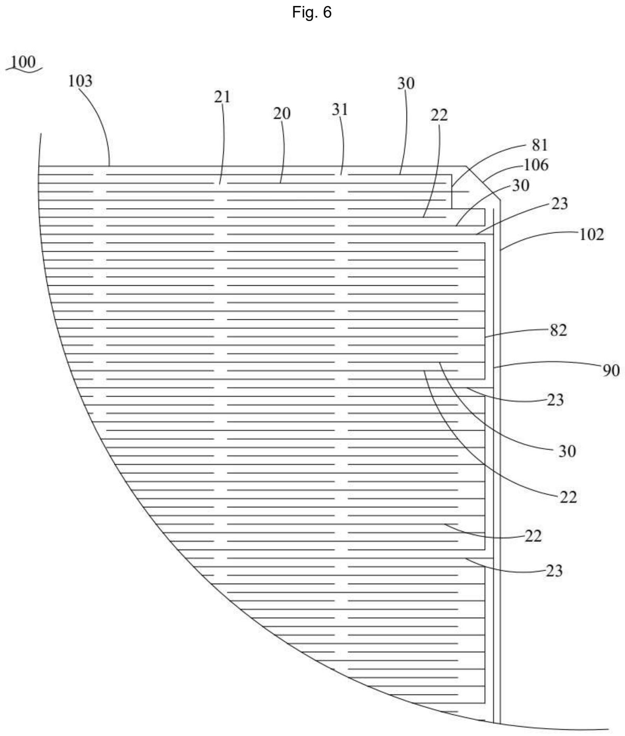

With reference to Fig. 6, in some examples, a third edge combination grid line 80 may include a first combination section 81 and a second combination section 82. The first combination section 81 is connected to a second finger 30 located at a second chamfer 106. Similarly, in such examples, "the second finger 30 located at the first chamfer 106" indicates the second finger 30 that is not directly connected to the third edge combination grid line 80 and crosses the second chamfer 106 along an extension line of a second direction among several second fingers 30, for example, top two second fingers 30 in Fig. 6. The second combination section 81 is connected to the second finger 30 except the second finger at the second chamfer 106. It can be understood that as shown in Fig. 6, in such an example, the second combination section 82 has a discontinuous structure due to existence of a second penetrating finger 23.

In this way, the second fingers 30 at the second chamfer 106 may be connected into a whole through the first combination section 81. When a solder strip is arranged, in order to implement current combination of the second fingers 30 at the second chamfer 106, the current combination of all the second fingers 30 at the second chamfer 106 may be implemented merely through contact of the solder strip with any second finger 30 at the second chamfer 106.

Further, as shown in Fig. 6, in such an example, the first combination section 81 and the second combination section 82 are arranged at an interval in the second direction, and the second combination section 82 is closer to the second edge 102 than the first combination section 81.

Specifically, in such an example, a top end of the first combination section 81 may be connected to an end of a topmost second finger 30 and extend in a first direction, such that all the second fingers 30 at the second chamfer 106 may be connected into a whole.

It is not difficult to understand that this example is different from Example 10 merely in that the second fingers 30 at the second chamfer 106 are connected into a whole by arranging the third auxiliary grid line 110 parallel to the second chamfer 106 in Example 10, while the second fingers 30 at the second chamfer 106 are connected into a whole through the first combination section 81 in this example, which may be used at the same time and are not limited specifically herein.

### Embodiment 12

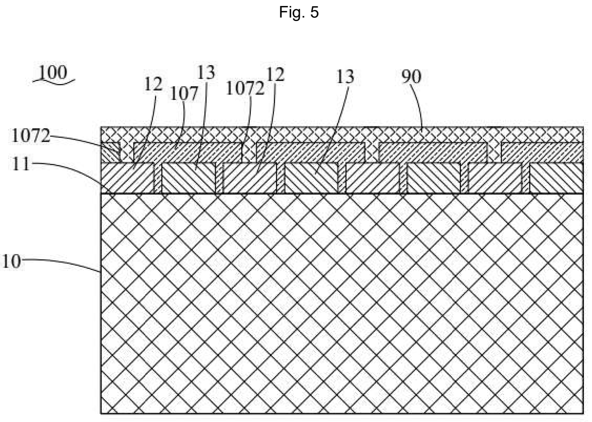

With reference to Fig. 5, passivation film layers 107 are arranged on a first doped layer 12 and a second doped layer 13, a fourth edge combination grid line 90 is arranged on the passivation film layer 107, a second opening 1072 is provided in a position, corresponding to the first doped layers 12, of the passivation film layer 107 on an area (a projection area of the fourth edge combination grid line 90 on the passivation film layer 107) corresponding to the fourth edge combination grid line 90, and the fourth edge combination grid line 90 is in contact with the first doped layers 12 through the second opening 1072.

In this way, by providing the second opening 1072 in the position, corresponding to the first doped layers 12 in the passivation film layer 107, the fourth edge combination grid line 90 can be in stable contact with the first doped layers 12 at a bottom of an edge area during printing so as to collect currents, and electric leakage caused by contact between the fourth edge combination grid line 90 and the second doped layers 13 can also be avoided.

Specifically, in such an example, the second opening 1072 may be provided in the passivation film layer 107 through laser hole cutting. In order to maximize current collection, the second openings 1072 are cut in all the first doped layers 12 preferably, and the fourth edge combination grid line 90 is in contact with all the first doped layers 12 through the second openings 1072 so as to maximize the current collection. It is clear that in some examples, the second openings 1072 may alternatively be provided in some of the first doped layers 12, which is not limited specifically herein.

### Embodiment 13

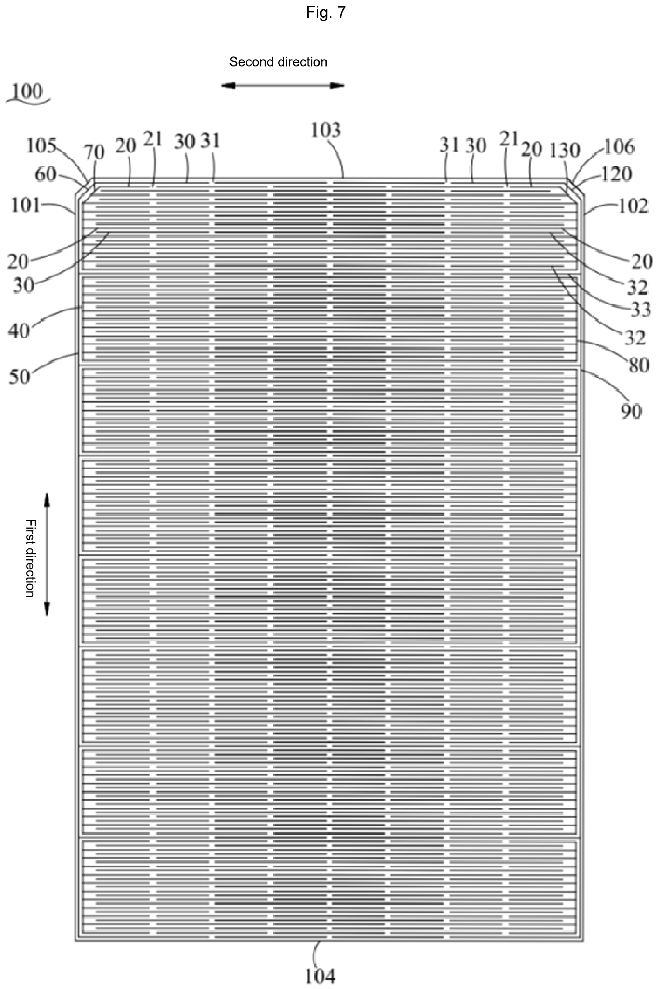

With reference to Fig. 7, in some example, a third edge combination grid line 80 may alternatively be electrically connected to a first finger 20, the first finger 20 does not extend to a second edge 102 of a silicon substrate 10, and the third edge combination grid line 80 and a first edge combination grid line 40 have the same polarity.

In addition, in such an example, a fourth edge combination grid line 90 and a second edge combination grid line 50 has the same polarity, and the fourth edge combination grid line is in contact with at least one of second doped layers 13 and is electrically connected to an end of a portion, closest to the second edge 102, of the second finger 30.

In such an example, the example is different from the instance in Fig. 1 in that in the instance shown in Fig. 7, the third edge combination grid line 80 and the first edge combination grid line 40 has the same polarity, and the fourth edge combination grid line 90 and the second edge combination grid line 50 has the same polarity, while in the instance shown in Fig. 1, the third edge combination grid line 80 and the first edge combination grid line 40 have opposite polarities, and the fourth edge combination grid line 90 and the second edge combination grid line 50 have opposite polarities.

Specifically, in such an example, the third edge combination grid line 80 and the fourth edge combination grid line 90 that are at the second edge 102 are symmetrical with the first edge combination grid line 40 and the second edge combination grid line 50 that are at the first edge 101, and have the same structures as the first edge combination grid line and the second edge combination grid line at the first edge 101. A number of a first discontinuous areas 21 and a number of second discontinuous areas 31 are odd numbers.

It can be understood that in such an example, structures and materials of the third edge combination grid line 80 and the first edge combination grid line 40 are basically the same, and structures and materials of the fourth edge combination grid line 90 and the second edge combination grid line 50 are basically the same, which will not be repeated herein.

Similarly, as shown in Fig. 7, it is not difficult to understand that the fourth edge combination grid line 90 is in contact with the second doped layers 13 to collect the currents of the second doped layers 13 in the edge area of the second edge 102. Thus, as shown in Fig. 7, in this example, of the first discontinuous area 21 of the first finger 20 and the second discontinuous area 31 of the second finger 30, the first discontinuous area 21 is also closest to the second edge 102. That is, in the second direction, the first discontinuous areas 21 and the second discontinuous areas 31 are arranged alternately in sequence, and a discontinuous area closest to the second edge 102 is also the first discontinuous area 21. At a position corresponding to the first discontinuous area 21, the second finger 30 is not separated, and the busbar and/or the solder point in contact with the second finger 30 may be arranged at the position corresponding to the first discontinuous area 21, so as to combine the currents of the third edge combination grid line 80.

### Embodiment 14

With reference to Fig. 7, in some examples, some of second fingers 30 penetrate a third edge combination grid line 80 in an insulated way so as to be electrically connected to a fourth edge combination grid line 90.

In this way, after the fourth edge combination grid line 90 collects currents of an edge area of a second edge 102, the fourth edge combination grid line may combine the currents to a nearest busbar and/or solder strip having the same polarity through the second finger 30 penetrating the third edge combination grid line 80, so as to implement current collection.

Specifically, as shown in Fig. 7 and described above, in such an example, several second fingers 30 may include several first collecting fingers 32 and several first penetrating fingers 33. For the second edge 102, the several first collecting fingers 32 are all located on a side, facing a first edge 101, of the third edge combination grid line 80, and the first penetrating fingers 33 penetrate the third edge combination grid line 80 in an insulated way so as to be connected to the fourth edge combination grid line 90.

That is, in such an example, no first collecting finger 32 is arranged between the third edge combination grid line 80 and the second edge 102. Between the fourth edge combination grid line 90 and the second edge 102, merely a position penetrated by the third edge combination grid line 80 has the first penetrating finger 33.

It should be noted that in the example of the disclosure, a case that "some of the second fingers 30 penetrate the third edge combination grid line 80 in an insulated way" may be understood as that several spaced partition areas are arranged on the third edge combination grid line 80 in a first direction, and the first penetrating fingers 33 pass through the third edge combination grid line 80 through the partition areas without being in contact with the third edge combination grid line 80, so as to implement physical penetration and insulated isolation.

Similarly, in such an example, one or more first penetrating fingers 33 may be arranged, and a specific number of first penetrating fingers may be determined according to a size of the cell. When a plurality of first penetrating fingers 33 are arranged, the plurality of first penetrating fingers 33 may be spaced in the first direction, and a distance between two adjacent first penetrating fingers 33 may be determined according to the size of the cell. Preferably, the first penetrating fingers may be uniformly spaced on a silicon substrate 10 in the first direction according to a size of the silicon substrate 10, which is not limited specifically herein.

It should be noted that in such an example, the first penetrating finger 33 penetrating the third edge combination grid line 80 may be the same grid line as the first penetrating finger penetrating the first edge combination grid line 40 or not, which is not limited specifically herein. The two first penetrating fingers are the same grid line preferably. When the two first penetrating fingers are the same grid line, a grid line structure at the first edge 101 and a grid line structure at the second edge 102 are completely symmetrical.

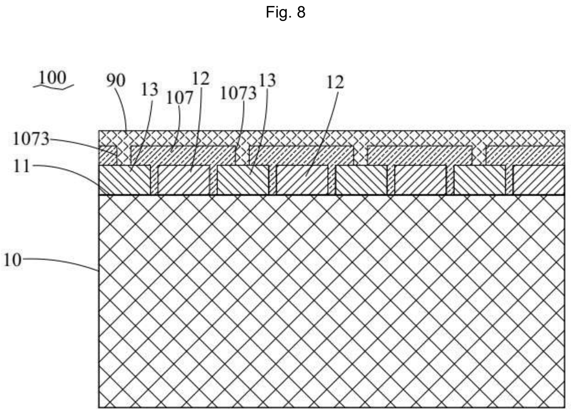

With reference to Fig. 8, in such an example, a third opening 1073 is provided in a position, corresponding to the second doped layers 13, of the passivation film layer 107 on an area (a projection area of the fourth edge combination grid line 90 on the passivation film layer 107) corresponding to the fourth edge combination grid line 90, and the fourth edge combination grid line 90 is in contact with the second doped layers 13 through the third opening 1073.

In this way, by providing the third opening 1073 in the position, corresponding to the second doped layers 13 in the passivation film layer 107, the fourth edge combination grid line 90 can be in stable contact with the second doped layers 13 at a bottom of an edge area during printing so as to collect currents, and electric leakage caused by contact between the fourth edge combination grid line 90 and the first doped layers 12 can also be avoided.

Specifically, in such an example, structures of the fourth edge combination grid line 90 and the third opening 1073 may be the same as and symmetrical with structures of the second edge combination grid line 50 and the first opening 1071. In this example, the third opening 1073 may be provided in the passivation film layer 107 through laser hole cutting. In order to maximize current collection, the third openings 1073 are cut in all the second doped layers 13, and the fourth edge combination grid line 90 is in contact with all the second doped layers 13 through the three openings 1073 so as to maximize the current collection. It is clear that in some examples, the third openings 1073 may alternatively be provided in some of the second doped layers 13, which is not limited specifically herein.

### Embodiment 15

With reference to Fig. 7, in some examples, in a first direction, a silicon substrate 10 has a third edge 103 and a fourth edge 104 that are opposite, and the third edge 103 is connected to a second edge 102 through a second chamfer 106.

Second fingers 30 and first fingers 20 are arranged alternately in sequence in a direction from the third edge 103 to the fourth edge 104, a fourth auxiliary grid line 120 is arranged at the second chamfer 106, and the fourth auxiliary grid line 120 connects a fourth second edge combination grid line 90 and the second finger 30 closest to the third edge 103.

In this way, by arranging the fourth auxiliary grid line 120 at the second chamfer 106, currents collected by the fourth edge combination grid line 90 can be combined to the second finger 30 at the third edge 103 so as to be combined to a nearest busbar and/or solder strip.

Specifically, as shown in Fig. 7, the third edge 103 is an upper edge of the silicon substrate 10, the fourth edge 104 is a lower edge of the silicon substrate 10, a first edge 101 and the third edge 103 form a first chamfer 105, and the second edge 102 and the third edge 103 form the second chamfer 106.

As shown in Fig. 7, in such an example, the first chamfer 105 is symmetrical with the second chamfer 106, and the fourth auxiliary grid line 120 is symmetrical with the first auxiliary grid line 60.

It can be understood that in such an example, a first penetrating finger 33 may be arranged to implement current combination with a third auxiliary grid line 110. The first penetrating finger 33 may alternatively be not arranged, but the current combination may be implemented through the fourth auxiliary grid line 120 at the second chamfer 106. It is clear that in order to avoid excessive loss caused by an excessively long transfer path of the current combination, the current is preferably combined through the first penetrating finger 33 or through both the first penetrating finger 33 and the fourth auxiliary grid line 120, which is not limited herein.

In some examples, the fourth auxiliary grid line 120 is arranged parallel to the second chamfer 106. In this way, a grid line structure of a back surface 11 can become simpler to manufacture.

Further, in some examples, the fourth auxiliary grid line 120 may be located above second doped layers 13 and is in contact with at least one of the second doped layers 13.

In this way, the fourth auxiliary grid line 120 can collect the currents at an edge area at a position of the second chamfer 106 while implementing the current combination, thus further reducing efficiency loss and improving efficiency of a cell.

With reference to Fig. 7, in some examples, a fifth auxiliary grid line 130 may be further arranged at the first chamfer 105. The fifth auxiliary grid line 130 connects the first finger 20 located at the second chamfer 106 to the third edge combination grid line 80. Similarly, it should be noted that "the second finger 30 located at the second chamfer 106" indicates the second finger 30 that is not directly connected to the third edge combination grid line 80 and crosses the second chamfer 106 along an extension line of the third direction among the several three fingers 30, for example, two uppermost second fingers 30 in Fig. 7.

In this way, the first fingers 20 at the second chamfer 106 can be connected through the arrangement of the fifth auxiliary grid line 130 so as to implement communication between the first fingers 20 at the first chamfer 106. When the solder strip is soldered later, the currents of the first finger 20 at the second chamfer 106 can be collected merely through contact between the solder strip and the fifth auxiliary grid line 130. A case that the currents of the first finger 20 at the second chamfer 106 cannot be collected since the solder strip 202 cannot be in contact with all the first fingers 20 at the second chamber 106 when the solder strip 202 is soldered later due to existence of the second chamfer 106 can be avoided.

Specifically, as shown in Fig. 7, in such an example, the fifth auxiliary grid line 130 may alternatively be arranged parallel to the second chamfer 106. That is, at the second chamfer 106, the second chamfer 106, the fourth auxiliary grid line 120 and the fifth auxiliary grid line 130 are sequentially arranged parallel to one another from an outer side to an inner side, and the fifth auxiliary grid line 130 is symmetrical with a second auxiliary grid line 70.

### Embodiment 16

**In** some examples, a distance between a third edge combination grid line 80 and a second edge 102 (that is, a gap between the third edge combination grid line and the second edge in a second direction) is 0.5 mm-2 mm.

**In** this way, if the gap between the third edge combination grid line 80 and the second edge 102 is set within this reasonable range, a case that excessively high efficiency loss is caused since an area without the finger is excessively large due to an excessively large distance between the third edge combination grid line and the second edge can be effectively avoided, a case that insufficient solder and cracking are caused by an excessively small distance between the third edge combination grid line and the second edge when the solder strip is soldered at the third edge combination grid line 80 later can be also avoided, and reliability and stability of soldering are guaranteed.

Specifically, in such an example, the distance between the third edge combination grid line 80 and the second edge 102 may be, for example, 0.5 mm, 0.6 mm, 0.7 mm, 0.8 mm, 0.9 mm, 1 mm, 1.2 mm, 1.4 mm, 1.6 mm, 1.8 mm, 2 mm or any value within 0.5 mm-2 mm, which is not limited specifically herein.

Further, in the example of the disclosure, the distance between the third edge combination grid line 80 and the second edge 102 is preferably 0.8 mm-1.2 mm, for example, 0.9 mm. In this way, while the process difficulty can be reduced, the excessively high efficiency loss caused by an excessively large area of the edge area without the finger due to the excessively large distance can be effectively avoided, and the stability and reliability of soldering can also be guaranteed.

### Embodiment 17

In some examples, a distance between a fourth edge combination grid line 90 and a second edge 102 (that is, a gap between the fourth edge combination grid line and the second edge in a second direction) is 0.3 mm-1.2 mm

In this way, on the one hand, a great increase in printing difficulty of the fourth edge combination grid line 90 due to an excessively small distance between the fourth edge combination grid line 90 and the second edge 102 can be avoided, and on the other hand, excessively high efficiency loss caused by an excessively large area of the area without the finger due to the excessively large distance between the fourth edge combination grid line 90 and the second edge 102 can be avoided.

Specifically, in such an example, the distance between the fourth edge combination grid line 90 and the second edge 102 may be, for example, 0.3 mm, 0.4 mm, 0.5 mm, 0.6 mm, 0.7 mm, 0.8 mm, 0.9 mm, 1 mm, 1.2 mm or any value within 0.3 mm-1.2 mm, which is not limited specifically herein.

Further, in the example of the disclosure, the distance between the fourth edge combination grid line 90 and the second edge 102 is preferably 0.3mm-0.6mm, for example, 0.5 mm. In this way, while the process difficulty can be reduced, the excessively high efficiency loss caused by an excessively large area of the edge area without the finger due to the excessively large distance can be effectively avoided. That is, while the printing difficulty can be reduced, the excessively high efficiency loss can be avoided.

### Embodiment 18

In some examples, a width of a fourth edge combination grid line 90 is within 20 um-200 um.

In this way, by setting the width of the fourth edge combination grid line 90 within this reasonable range, the phenomenon of fusing during current combination due to an excessively small overcurrent capacity caused by an excessively small width of the fourth edge combination grid line 90 can be avoided, and a great increase in cost caused by an excessively large width of the fourth edge combination grid line 90 can also be avoided.

Specifically, in such an example, the width of the fourth edge combination grid line 90 may be, for example, 20 um, 20 um, 30 um, 40 um, 50 um, 60 um, 70 um, 80 um, 90 um, 100 um, 110 um, 120 um, 130 um, 140 um, 150 um, 160 um, 170 um, 180 um, 190 um, 200 um or any value within 20 um-200 um, which is not limited specifically herein.

In some examples, the width of the fourth edge combination grid line 90 is greater than a width of a third edge combination grid line 80.

In this way, since the fourth edge combination grid line 90 is used for collecting currents of second doped layers 13 in an edge area, and plays a role of collection and combination, the width of the fourth edge combination grid line 90 may be set to be greater than the width of the third edge combination grid line 80, in order to improve an overcurrent capacity of the fourth edge combination grid line 90 and guarantee stability of a cell.

### Embodiment 19

In some examples, in a second direction, a back-contact cell 100 may further include first busbars (not shown in the figure) and second busbars (not shown in the figure) alternately in sequence, the first busbars are arranged at a first discontinuous area 31 and are in contact with the first fingers 20, and the second busbars are arranged at a first discontinuous area 21 and are in contact with the second fingers 30. In this way, through the arrangement of the first busbar and the second busbar, combination and output of currents can be implemented.

Specifically, in such an example, the first busbar is arranged at the second discontinuous area 31 of the second finger 30 to be in contact with the first finger 20 and implement current output, and the second busbar is arranged at the first discontinuous area 21 of the first finger 20 to be in contact with the second finger 30 and implement current output.

In addition, it can be understood that, as shown in Fig. 8, in some examples, the back-contact cell 100 may not be provided with the busbar, but with solder strips 202 at corresponding positions of the first discontinuous area 21 and the second discontinuous area 31 so as to form a battery string 201 and implement current combination output. That is, the busbar may be replaced with the solder strip 202.

### Embodiment 20

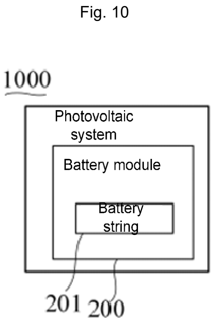

With reference to Fig. 9 and Fig. 10, the disclosure further provides a photovoltaic system 1000. The photovoltaic system 1000 may include the battery module 200 in the example of the disclosure. The battery module 200 in the example of the disclosure may include several battery strings 201 in the example of the disclosure. As shown in Fig. 9, the battery string 201 may include several back-contact cells 100 and several solder strips 202 in the example of the disclosure.

It can be understood that the back-contact cell 100 in the example of the disclosure may be an overall battery or a half battery, which is not limited specifically herein.

As shown in Fig. 9, in two adjacent back-contact cells 100, a first discontinuous area 21 of one back-contact cell 100 corresponds to a second discontinuous area 31 of the other back-contact cell 100 in a first direction. The solder strips 202 are arranged at the first discontinuous areas 21 and the second discontinuous areas 31, and the first discontinuous areas 21 and the second discontinuous areas 31 each are correspondingly provided with one solder strip 202.

In two adjacent back-contact cells 100, a first finger 20 of one back-contact cell 100 is connected to the solder strip 202 at the first discontinuous area 21, and a second finger 30 of the other back-contact cell 100 is connected to the solder strip 202 at the second discontinuous area 31.

In the battery string 201 of the example of the disclosure, there are several connection modes as follows:
1. As shown in Fig. 9, in two adjacent back-contact cells 100, a first edge 101 has a first edge combination grid line 40 and a second edge combination grid line 50, and the second edge 102 has a third edge combination grid line 80 and a fourth edge combination grid line 90. The first edge combination grid line 40 and the third edge combination grid line 80 have opposite polarities, and the second edge combination grid line 50 and the fourth edge combination grid line 90 have opposite polarities.
   In two adjacent back-contact cells 100 of the battery string 201, the first edge 101 of one back-contact cell is aligned with the second edge 102 of the other back-contact cell, such that the first edge combination grid line 40 and the third edge combination grid line 80 in the two cells are located on the same side, and the second edge combination grid line 50 and the fourth edge combination grid line 90 are located on the same side. In the two back-contact cells 100, a middle area is connected through the solder strip 202, edge areas are soldered together in series through edge solder strips 203 located at the first edge 101 and the second edge 102, and it is merely necessary to coat an insulating glue between the edge solder strip 203 and a grid line (for example, a first penetrating finger 33 and a second penetrating finger 23 in Fig. 9) having an opposite polarity. As shown in Fig. 8, the edge solder strips 203 are electrically connected to the first edge combination grid line 40 and the third edge combination grid line 80 located at the same side. The edge solder strip 203 may be arranged in a first direction, and may be soldered to the first edge combination grid line 40 and the third edge combination grid line 80 or to the first finger 20 and the second finger 30.
2. In two adjacent back-contact cells 100, merely the first edge 101 has the first edge combination grid line 40 and the second edge combination grid line 50.

In this case, in two adjacent back-contact cells 100, the first edge combination grid lines 40 located on the same side have opposite polarities, the first edge combination grid line and the first finger of the first edge combination grid line 40 have opposite polarities, the second edge combination grid lines 50 have opposite polarities. That is, in two adjacent back-contact cells 100, the first edge combination grid line 40 of one back-contact cell is a P-type grid line, the first edge combination grid line 40 of the other back-contact cell is a N-type grid line, and two back-contact cells 100 are soldered together in series through the solder strip located at the first edge 101.

As shown in Fig. 9, in some examples, in the battery string 201, the edge solder strip 203 may be directly soldered to the first edge combination grid line 40 and the third edge combination grid line 80 in a contact or covered way. It is clear that in some examples, the edge solder strips 203 may alternatively be located at inner sides (that is, on a side, facing away from the first edge 101, of the first edge combination grid line 40) of the first edge combination grid line 40 and the third edge combination grid line 80. In two adjacent back-contact cells 100, the edge solder strip 203 in one back-contact cell 100 is soldered to the first finger 20, and the edge solder strip 203 in the other back-contact cell 100 is soldered to the second finger 30.

It can be understood clearly that in some examples, busbars may be provided at both the first discontinuous area 21 and the second discontinuous area 31, and the solder strip 202 may be soldered to a first busbar and a second busbar described above. That is, in the disclosure, the back-contact cell 100 may be a cell having the busbar or a cell not having the busbar, which is not limited specifically herein.

In the explanation of the description, the explanation with reference to terms such as "some examples", "illustrative example", "instance", "specific instance" or "some instances" indicates that specific features, structures, materials, or characteristics described in combination with the example or the instance are included in at least one example or instance of the disclosure. In this description, illustrative expressions of the terms do not necessarily refer to the same example or instance. In addition, the specific features, structures, materials or characteristics described may be combined in any one or more examples or instances in a suitable manner.

Further, the examples described above are merely preferred examples of the disclosure but are not intended to limit the disclosure, and any modification, equivalent replacement, improvement, etc. made within the spirit and principles of the disclosure should fall within the protection scope of the disclosure.

## Claims

1. A back-contact cell, comprising:
a silicon substrate, wherein a back surface of the silicon substrate is provided with several first doped layers and several second doped layers, the first doped layers and the second doped layers are arranged alternately in sequence in a first direction and extend in a second direction, the first direction and the second direction cross each other, and in the second direction, the silicon substrate has a first edge and a second edge that are opposite each other;
several first fingers and several second fingers that are spaced alternately in the first direction, wherein the first fingers are arranged above the first doped layers, and the second fingers are arranged above the second doped layers; the first fingers have several first discontinuous areas which are spaced in the second direction, the second fingers have several second discontinuous areas which are spaced in the second direction, the first discontinuous areas on adjacent first fingers correspond in the first direction, and the second discontinuous areas on adjacent second fingers correspond in the first direction; and the first discontinuous areas and the second discontinuous areas are spaced alternately in sequence in the second direction, and the first fingers do not extend to the first edge of the silicon substrate;
a first edge combination gird line arranged close to the first edge and extending in the first direction, wherein the first edge combination gird line is electrically connected to the first fingers; and
a second edge combination gird line extending in the first direction, wherein the second edge combination gird line is arranged between the first edge combination gird line and the first edge and is located above the second doped layers, and the second edge combination gird line is in contact with at least one of the second doped layers and is electrically connected to an end of a portion, closest to the first edge, of the second fingers.

2. The back-contact cell according to claim 1, wherein some of the second fingers penetrate the first edge combination gird line in an insulated way so as to be electrically connected to the second edge combination gird line.

3. The back-contact cell according to claim 1, wherein in the first direction, the silicon substrate further has a third edge and a fourth edge that are opposite, and the third edge is connected to the first edge through a first chamfer; and
the second fingers and the first fingers are arranged alternately in sequence in a direction from the third edge to the fourth edge, a first auxiliary gird line is arranged at the first chamfer, and the first auxiliary gird line connects the second edge combination gird line and the second fingers closest to the third edge.

4. The back-contact cell according to claim 3, wherein the first auxiliary gird line is located above the second doped layers and is in contact with at least one of the second doped layers.

5. The back-contact cell according to claim 3, wherein the first auxiliary gird line is parallel to the first chamfer.

6. The back-contact cell according to claim 1, wherein in the first direction, the silicon substrate further has a third edge and a fourth edge that are opposite, and the third edge is connected to the first edge through a first chamfer; and
a second auxiliary gird line is arranged at the first chamfer, and the second auxiliary gird line connects the first fingers at the first chamfer and the first edge combination gird line.

7. The back-contact cell according to any one of claims 1-6, wherein a distance between the first edge combination gird line and the first edge is 0.5 mm-2 mm; and/or
a distance between the second edge combination gird line and the first edge is 0.3 mm-1.2 mm.

8. The back-contact cell according to any one of claims 1-6, wherein a width of the second edge combination gird line is 20 um-200 um; and/or
a width of the second edge combination gird line is greater than a width of the first edge combination gird line.

9. The back-contact cell according to claim 1, wherein passivation film layers are further arranged on the first doped layer and the second doped layers, the second edge combination gird line is arranged on the passivation film layer, a first opening is provided in a position, corresponding to the second doped layers, of the passivation film layer on an area corresponding to the second edge combination gird line, and the second edge combination gird line is in contact with the second doped layers through the first opening.

10. The back-contact cell according to claim 1, further comprising:
a third edge combination gird line arranged close to the second edge and extending in the first direction, wherein the third edge combination gird line is electrically connected to the second fingers, the second fingers do not extend to the second edge of the silicon substrate, and the third edge combination gird line and the first edge combination gird line have opposite polarities; and
a fourth edge combination gird line extending in the first direction, wherein the fourth edge combination gird line is arranged between the third edge combination gird line and the second edge and is located above the first doped layer, and the fourth edge combination gird line is in contact with at least one of the first doped layers and is electrically connected to an end of a portion, closest to the second edge, of the first fingers.

11. The back-contact cell according to claim 10, wherein some of the first fingers penetrate the third edge combination gird line in an insulated way so as to be connected to the fourth edge combination gird line.

12. The back-contact cell according to claim 10, wherein in the first direction, the silicon substrate further has a third edge and a fourth edge that are opposite, and the third edge is connected to the second edge through a second chamfer; and
the second fingers and the first fingers are arranged alternately in sequence in a direction from the third edge to the fourth edge, a third auxiliary gird line is arranged at the second chamfer, and the third auxiliary gird line connects the second fingers at the second chamfer and the third edge combination gird line.

13. The back-contact cell according to claim 12, wherein the third auxiliary gird line is parallel to the second chamfer.

14. The back-contact cell according to claim 10, wherein in the first direction, the silicon substrate further has a third edge and a fourth edge that are opposite, and the third edge is connected to the second edge through a second chamfer; and
the third edge combination gird line comprises a first combination section and a second combination section, the first combination section is connected to the second fingers located at the second chamfer, and the second combination section is connected to the second fingers except the second fingers at the second chamfer.

15. The back-contact cell according to claim 14, wherein the first combination section and the second combination section are arranged at an interval in the second direction, and the second combination section is closer to the second edge than the first combination section.

16. The back-contact cell according to claim 10, wherein passivation film layers are further arranged on the first doped layer and the second doped layers, the fourth edge combination gird line is arranged on the passivation film layer, a second opening is provided in a position, corresponding to the first doped layer, of the passivation film layer on an area corresponding to the fourth edge combination gird line, and the fourth edge combination gird line is in contact with the first doped layer through the second opening.

17. The back-contact cell according to claim 1, further comprising:
a third edge combination gird line arranged close to the second edge and extending in the first direction, wherein the third edge combination gird line is electrically connected to the first fingers, the first fingers do not extend to the second edge of the silicon substrate, and the third edge combination gird line and the first edge combination gird line have the same polarity; and
a fourth edge combination gird line arranged close to the second edge and extending in the first direction, wherein the fourth edge combination gird line is arranged between the third edge combination gird line and the second edge, the fourth edge combination gird line is located above the second doped layers, and the fourth edge combination gird line is in contact with at least one of the second doped layers and is electrically connected to an end of a portion, closest to the second edge, of the second fingers.

18. The back-contact cell according to claim 17, wherein some of the second fingers penetrate the third edge combination gird line in an insulated way so as to be connected to the fourth edge combination gird line.

19. The back-contact cell according to claim 17, wherein in the first direction, the silicon substrate further has a third edge and a fourth edge that are opposite, and the third edge is connected to the second edge through a second chamfer; and
the second fingers and the first fingers are arranged alternately in sequence in a direction from the third edge to the fourth edge, a fourth auxiliary gird line is arranged at the second chamfer, and the fourth auxiliary gird line connects the fourth edge combination gird line and the second fingers closest to the third edge.

20. The back-contact cell according to claim 19, wherein the fourth auxiliary gird line is located above the second doped layers and is in contact with at least one of the second doped layers.

21. The back-contact cell according to claim 19, wherein the fourth auxiliary gird line is parallel to the second chamfer.

22. The back-contact cell according to claim 17, wherein in the first direction, the silicon substrate further has a third edge and a fourth edge that are opposite, and the third edge is connected to the second edge through a second chamfer; and
a fifth auxiliary gird line is further arranged at the second chamfer, and the fifth auxiliary gird line connects the first fingers at the second chamfer and the third edge combination gird line.

23. The back-contact cell according to claim 17, wherein passivation film layers are further arranged on the first doped layer and the second doped layers, the fourth edge combination gird line is arranged on the passivation film layer, a third opening is provided in a position, corresponding to the second doped layers, of the passivation film layer on an area corresponding to the fourth edge combination gird line, and the fourth edge combination gird line is in contact with the second doped layers through the third opening.

24. The back-contact cell according to any one of claims 10-23, wherein a distance between the third edge combination gird line and the second edge is 0.5 mm-2 mm; and/or
a distance between the fourth edge combination gird line and the second edge is 0.3 mm-1.2 mm.

25. The back-contact cell according to any one of claims 10-23, wherein a width of the fourth edge combination gird line is 20 um-200 um; and/or
a width of the fourth edge combination gird line is greater than a width of the third edge combination gird line.

26. The back-contact cell according to claim 1, wherein in the second direction, the back-contact cell is further provided with first busbars and second busbars alternately in sequence, the first busbars are arranged at the first discontinuous area and are in contact with the first fingers, and the second busbars are arranged at the second discontinuous area and are in contact with the second fingers.

27. A battery string, comprising several back-contact cells according to any one of claims 1-26, wherein in two adjacent back-contact cells, a first discontinuous area of one back-contact cell corresponds to a second discontinuous area of the other back-contact cell in a first direction.

28. A battery module, comprising several battery strings according to claim 27.

29. A photovoltaic system, comprising the battery module according to claim 28.
